Europäisches Patentamt

European Patent Office

Office européen des brevets

(19)

(11) Numéro de publication : **0 309 362 B1**

# (12) FASCICULE DE BREVET EUROPEEN

(45) Date de publication du fascicule du brevet :
28.08.91 Bulletin 91/35

(51) Int. Cl.⁵ : **H05K 9/00**

(21) Numéro de dépôt : **88402411.8**

(22) Date de dépôt : **23.09.88**

(54) Joint composite à conducteur incorporé.

(30) Priorité : 25.09.87 FR 8713330

(43) Date de publication de la demande :
29.03.89 Bulletin 89/13

(45) Mention de la délivrance du brevet :
28.08.91 Bulletin 91/35

(84) Etats contractants désignés :
AT BE CH DE ES GB GR IT LI LU NL SE

(56) Documents cités :
EP-A- 0 207 005
WO-A- 84/02680
FR-A- 2 477 662
US-A- 1 912 255
US-A- 3 783 173

(73) Titulaire : **SAP SOCIETE AUTOMATIQUE DE PROFILAGE Société Anonyme:**
**Route de Paris**
**Gisors (Eure) (FR)**

(72) Inventeur : **Quiles, Georges**
**Résidence Symphonie 2, Rue Hector Berlioz**
**Bobigny (Seine Saint Denis) (FR)**

(74) Mandataire : **Rataboul, Michel Charles**
**CMR INTERNATIONAL 69, rue de Richelieu**
**F-75002 Paris (FR)**

Jouve, 18, rue Saint-Denis, 75001 PARIS

## Description

Il est parfois nécessaire de placer des joints élastiques entre deux parties mobiles l'une par rapport à l'autre, notamment à des fins d'isolation ou d'étanchéité. C'est le cas, par exemple, des portes de réfrigérateurs.

Pour certaines applications, ces joints doivent, en plus de leurs qualités propres, spécifiques de leur fonction de joint, s'adapter à des conditions d'emploi particulières.

On sait, par exemple, que les armoires et coffrets d'ensembles électroniques, notamment des ordinateurs, recueillent l'électricité statique issue du fonctionnement même de l'ensemble qu'ils renferment et que cette électricité statique doit être éliminée par conduction à la terre. Cela suppose une continuité électrique entre toutes les parties associées : châssis, cadres, supports, armoire ou coffret. Or, ces armoires et coffrets sont équipés de portes d'accès qui doivent recevoir un joint d'étanchéité afin de protéger l'ensemble électronique contre les poussières ambiantes en particulier. Si ces joints sont isolants il y a discontinuité électrique entre l'armoire et sa porte, de sorte que les fonctionnement de l'ensemble peut être gravement perturbé.

Pour éviter cela, on adopte des joints qui sont à la fois élastiques et conducteurs. Mais leur réalisation pratique présente des inconvénients.

En effet, de tels joints comprennent généralement deux éléments : un support substantiellement rigide, par exemple un ruban en acier inoxydable, et un joint proprement dit constitué par un profilé élastique.

L'association de ces deux éléments hétérogènes présente des difficultés car on ne peut pas les coller du fait que les colles connues actuellement pour cet usage sont isolantes et s'opposent à la continuité électrique que l'on recherche absolument.

Pour résoudre ce problème, on fixe le profilé sur le ruban sans colle et pour assurer leur fixation, on extrude le profilé en même temps que l'on fait défiler le ruban métallique, puis on provoque la stabilisation du profilé lorsqu'il est appliqué sur le ruban. En pratique, le profilé est réalisé en caoutchouc aux silicones et on fait passer l'ensemble ruban-profilé dans un four du vulcanisation.

Ainsi, on assure un contact intime et direct entre ces deux éléments conducteurs et le problème électrique est résolu puisqu'il n'y a aucun intermédiaire isolant.

Il est clair que ce procédé de fabrication présente des inconvénients car d'une part le procédé en soi est délicat à conduire par une main d'oeuvre qualifiée et d'autre part il nécessite une installation complexe, consommatrice d'énergie (le four de vulcanisation doit être chauffé à 240 degrés Celsius environ), tout cela conduisant à un prix de revient élevé.

La présente invention remédie à ces inconvénients en prévoyant un joint élastique à bonne conductivité électrique obtenu par un simple assemblage d'un profilé élastique pré-existant sur un ruban métallique.

A cette fin, l'invention a pour objet un joint composite, c'est-à-dire comprenant un ruban en métal et un profilé en matériau conducteur élastique rapporté, caractérisé en ce qu'au moins un conducteur est interposé et maintenu en contact permanent entre le ruban en métal et le profilé élastique, ces derniers étant fixés l'un à l'autre au moyen d'un adhésif disposé selon au moins deux zones longitudinales distinctes de celle(s) où se trouve(nt) le(s) conducteur(s).

Selon d'autres caractéristiques de l'invention :
— le profilé élastique comprend autant de rainures longitudinales qu'il y a de conducteurs afin que chacun de ceux-ci soit en partie engagé dans une rainure et immobilisé latéralement par celle-ci ;
— chaque conducteur est fixé au profilé, dans la rainure ;
— le profilé élastique présente des sillons longitudinaux pour chaque zone devant recevoir un adhésif ;
— le ruban en métal est dépoli, au moins sur l'étendue de la ou des zones devant recevoir un adhésif.

L'invention sera mieux comprise par la description détaillée ci-après faite en référence au dessin annexé. Bien entendu, la description et le dessin ne sont donnés qu'à titre d'exemple indicatif et non limitatif.

La figure 1 est une vue schématique en coupe d'un joint selon un premier mode de réalisation de l'invention.

La figure 2 est une vue schématique partielle en perspective de même joint que celui de la figure 1.

La figure 3 est une vue schématique en coupe d'un joint selon une deuxième mode de réalisation de l'invention.

La figure 4 est une vue schématique partielle en perspective du même joint que celui de la figure 3.

La figure 5 est une vue schématique de profil d'une installation conçue pour la fabrication d'un joint conforme à l'invention.

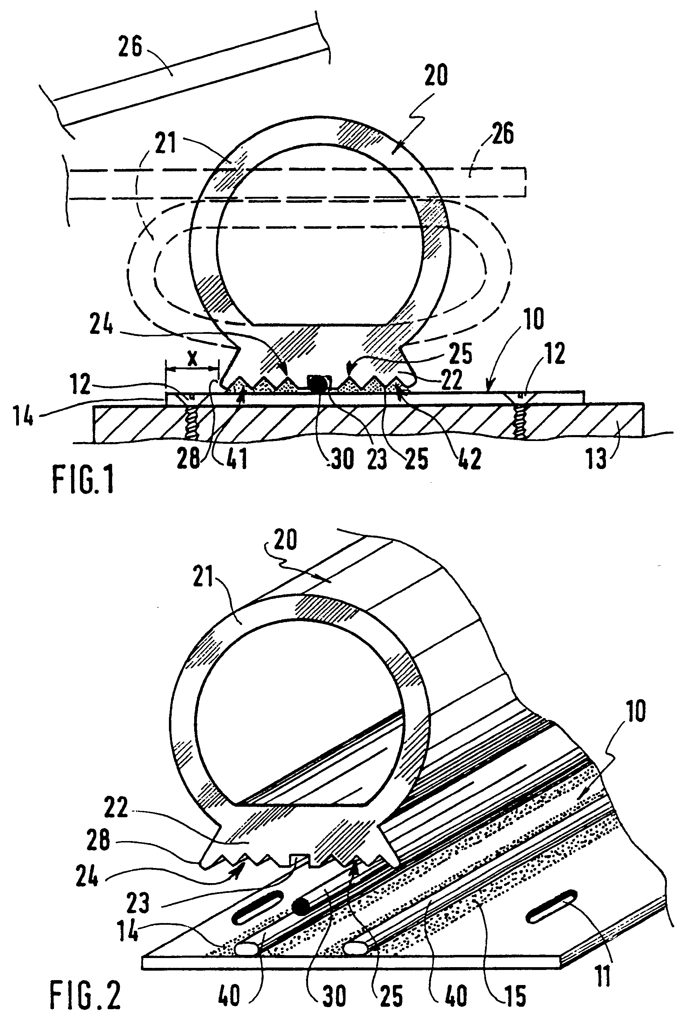

En se reportant aux figures 1 et 2, on voit un joint conforme à l'invention qui comporte un ruban 10 en acier inoxydable, un profilé 20 en caoutchouc aux silicones, un fil conducteur 30 et un adhésif 40 disposé selon deux zones 41 et 42, de part et d'autre du fil conducteur 30.

Le ruban 10 présente des ouvertures 11 permettant le passage de vis 12 pour sa fixation à une partie 13 telle qu'une armoire contenant des ensembles électroniques.

Le ruban 10 est dépoli selon deux zones 14 et 15 symétriques par rapport à son axe longitudinal.

La profilé 20 obtenu, par exemple, par extrusion, a une partie spécifiquement flexible creuse 21 à section générale tubulaire et une embase 22 pour sa fixation au ruban 10.

L'embase 22 présente une rainure longitudinale 23 de part et d'autre de laquelle se trouvent deux séries de sillons longitudinaux respectivement 24 et 25.

L'adhésif 40 est disposé selon deux cordons, sur les zones 14 et 15, et le fil conducteur 30 est placé dans l'axe du ruban 10 et engagé dans la rainure 23 du profilé 20.

Par pression relative du ruban 10 et du profilé 20, les cordons d'adhésif 40 s'étalent sur toute l'étendue des zones 14 et 15 et remplissent les sillons 24 et 25. Grâce au fait que le métal du ruban 10 est dépoli dans les zones 14 et 15, l'adhésif est fortement appliqué et maintient le profilé 20 sur le ruban 10, le fil conducteur 30 étant maintenu constamment au contact du ruban 10 et du profilé 20.

Cette fixation énergique garantit le contact permanent du fil conducteur 30 entre le ruban 10 et le profilé 20 et assure la continuité entre l'armoire 13 et une porte pivotante représentée schématiquement en 26. Sur la figure 1, on voit qu'en position de fermeture de la porte 26 représentée en trait pointillé, la partie tubulaire 21 est déformée tandis que l'embase 22 reste intacte.

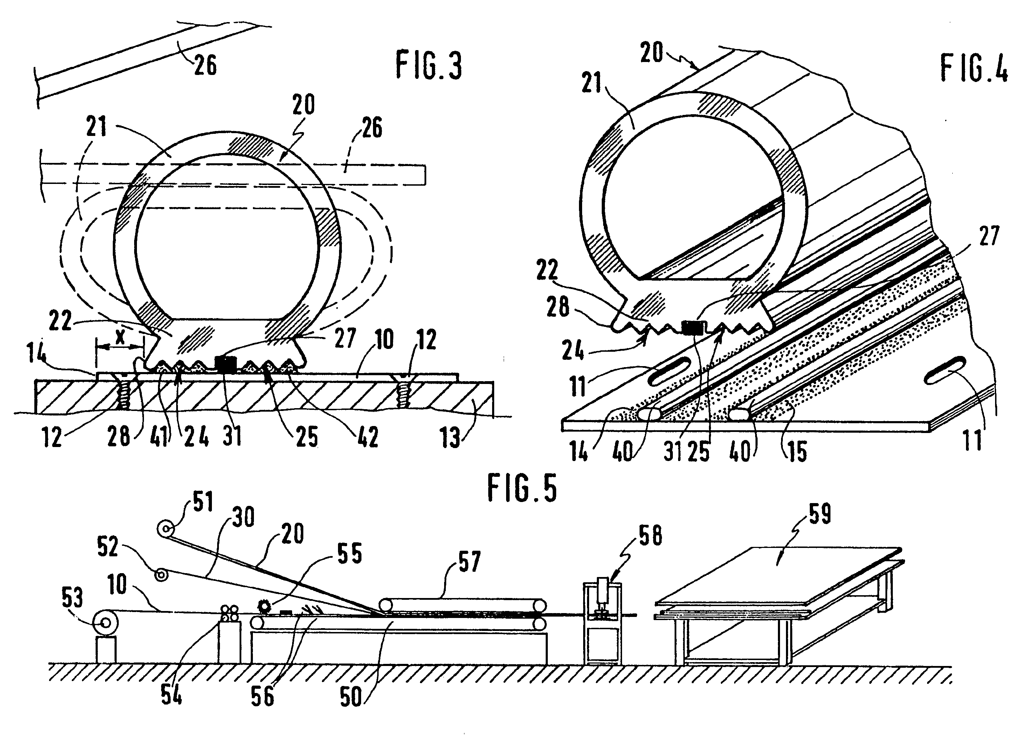

Sur les figures 3 et 4, on a représenté un autre mode de réalisation de l'invention, les mêmes éléments que ceux des figures 1 et 2 portant les mêmes références. Selon ce mode de réalisation, l'embase 22 présente une rainure longitudinale 27 dont la forme est adaptée à recevoir un élément conducteur 31 qui, ici, a une section rectangulaire propice à son maintient dans la rainure 27.

On peut, ainsi, adopter une procédé de fabrication un peu différent, comme on le verra plus loin.

Pour fabriquer le joint conforme à l'invention qui vient d'être décrit en regard des figures 1 et 2, on peut procéder de la manière suivante (figure 5) :

Les opérations s'effectuent en continu sur un tapis inférieur sans fin 50. En amont de ce tapis 50, se trouvent des dévidoirs 51 pour le profilé 20 préalablement extrudé et stocké en bobines, 52 pour le fil conducteur 30 et 53 pour le ruban (ou feuillard) 10.

On associe ces trois éléments par "accostage" ainsi :

Le ruban 10 est entraîné par des galets moteurs 54 et se pose sur le tapis 50 où il est dépoli par une meule à l'émeri rotative 55 selon les deux zones 14 et 15, puis est nettoyé par un tampon essuyeur imprégné d'un solvant sec (non représenté).

Sur le ruban 10, sont déposés les deux cordons d'adhésif 40 au moyen de buses calibrées 56 dans lesquelles l'adhésif pâteux est envoyé sous pression par une pompe. Les deux cordons sont disposés sur le ruban 10 de manière précise afin d'être bien à l'aplomb des sillons longitudinaux 24 et 25.

Le profilé 20 est extrait de sa bobine située sur le dévidoir 51 et est appliqué sur le ruban 10 par des guides (non représentés). Le guidage doit être très précis afin que les sillons 24 et 25 soient appliqués sur les cordons de colle 41 et 42 et que le bord 28 de l'embase 22 soit toujours à une distance x de la rive 14 du ruban 10. De la sorte, l'axe longitudinal du profilé 20 est toujours équidistant de la rive 14.

Un tapis supérieur 57 est entraîné en synchronisme avec le tapis inférieur 50. Ils assurent ensemble la pression relative du profilé 20 sur le ruban métallique 10. Les cordons d'adhésif 40 sont alors écrasés et l'adhésif est réparti dans les sillons 24 et 25 pour former un film aussi fin que possible.

Le pincement de l'ensemble 10-20-30-40 entre les tapis 50 et 57 permet d'introduire et de tracter le fil conducteur 30 dans la rainure 23.

Les cordons d'adhésif 40 sont calibrés de telle manière qu'ils ne débordent ni à l'extérieur du profilé 20 ni surtout vers le centre, là où se trouve le fil conducteur 30 afin d'éviter tout effet d'isolement.

Le temps de prise de l'adhésif est fonction de la nature de l'adhésif choisi et peut varier selon les conditions bien connues en soi de la polymérisation : température ambiante, humidité, usage d'un tunnel etc. On sait que ce temps est généralement compris entre 3 et 25 minutes.

A la sortie des tapis 50 et 57, l'ensemble passe dans une tronçonneuse 58 et les segments successifs sont recueillis sur une table de pré-stockage 59.

Le joint des figures 3 et 4 diffère de celui des figures 1 et 2 par le fait que le conducteur 31 est mis en place partiellement et immobilisé dans la rainure 27 de l'embase 22 avant le collage de celle-ci sur le ruban 10.

Pour la fixation du conducteur 31, on peut prévoir sa mise en place lors de l'extrusion du profilé 20, la fixation étant alors obtenue par adhérence naturelle de la matière extrudée sur le conducteur métallique 31.

L'intérêt de ce procédé est de supprimer le guidage du fil conducteur lors du collage du profilé 20 sur le ruban 10.

Les caractéristiques des matériaux constitutifs du profilé 20, du ruban 10, du conducteur 30-31 et de l'adhésif 40 n'ont pas être données en détail ici car elles sont à la portée de l'homme de métier.

## Revendications

1. Joint composite, c'est-à-dire comprenant un ruban en métal (10) et un profilé (20) en matériau conducteur élastique rapporté, caractérisé en ce qu' au moins un conducteur (30, 31) est interposé et maintenu en contact permanent entre le ruban en métal et le profilé élastique, ces derniers étant fixés l'un à l'autre au moyen d'un adhésif (40) disposé selon au moins deux zones longitudinales distinctes (41, 42) de celle(s) où se trouve(nt) le(s) conducteur(s).

2. Joint selon la revendication 1, caractérisé en ce que le profilé élastique (20) comprend autant de rainures (23, 27) longitudinales qu'il y a de conducteurs afin que chacun de ceux-ci soit en partie engagé dans une rainure et immobilisé latéralement par celle-ci.

3. Joint selon la revendication 2, caractérisé en ce que chaque conducteur est fixé au profilé (20), dans la rainure.

4. Joint selon la revendication 1, caractérisé en ce que le profilé élastique présente des sillons longitudinaux (24, 25) pour chaque zone devant recevoir un adhésif (40).

5. Joint selon la revendication 1, caractérisé en ce que le ruban en métal (10) est dépoli, au moins sur l'étendue de la ou des zones devant recevoir un adhésif (40).

**Patentansprüche**

1. Verbunddichtung, d. h. mit einem Band aus Metall (10) und einem angestückten Profil (20) aus leitendem elastischem Material, **dadurch gekennzeichnet,** daß wenigstens ein Leiter (30, 31) zwischen dem Metallband und dem elastischen Profil eingefügt und in dauerndem Kontakt gehalten ist, welche letzteren untereinander mittels eines Klebers (40) befestigt sind, der längs wenigstens zweier von der (denen) verschiedener Längszonen angeordnet ist, wo sich der (die) Leiter befindet (befinden).

2. Dichtung nach dem Anspruch 1, **dadurch g.·:ennzeichnet,** daß das elastische Profil (20) so viele Längsnuten (23, 27) aufweist, wie es Leiter gibt, damit deren jeder teilweise in eine Nut eingreift und durch diese seitlich festgelegt ist.

3. Dichtung nach dem Anspruch 2, **dadurch gekennzeichnet,** daß jeder Leiter am Profil (20) in der Nut befestigt ist.

4. Dichtung nach dem Anspruch 1, **dadurch gekennzeichnet,** daß das elastische Profil Längsrillen (24, 25) für jede Zone aufweist, die einen Kleber (40) aufnehmen muß.

5. Dichtung nach dem Anspruch 1, **dadurch gekennzeichnet,** daß das Metallband (10) wenigstens im Bereich der Zone oder Zonen mattiert ist, die einen Kleber (40) aufnehmen muß bzw. müssen.

**Claims**

1. Composite joint, that is to say one comprising a metal strip (10) and a section (20) of elastic conducting material affixed thereto, characterized in that at least one conductor (30, 31) is interposed and held in permanent contact between the metal strip and the elastic section, these last two being fixed to one another by means of an adhesive (40) in at least two longitudinal regions (41, 42) separate from the region(s) where the conductor(s) is/are found.

2. Joint according to claim 1, characterized in that the elastic section (20) includes as many longitudinal channels (23, 27) as there are conductors, so that each conductor is partly engaged in a channel and is laterally immobilised by the same.

3. Joint according to claim 2, characterized in that each conductor is fixed to the section (20), in the channel.

4. Joint according to claim 1, characterized in that the elastic section has longitudinal grooves (24, 25) for each region intended to receive an adhesive (40).

5. Joint according to claim 1, characterized in that the metal strip (10) is dulled at least over the region(s) intended to receive an adhesive (40).

FIG.1

FIG.2

FIG.3

FIG.4

FIG.5

EP 0 309 362 B1